# EUROPEAN PATENT SPECIFICATION

(11) **EP 1 653 494 B1**
(45) Date of publication and mention of the grant of the patent: **23.03.2011**
(21) Application number: 05022713.1
(22) Date of filing: 18.10.2005
(51) Int. Cl.: H01H 59/00

(54) **Micro thin-film structure, MEMS switch employing such a micro thin-film, and method of fabricating them**
Dünnschicht-Mikrostruktur, MEMS-Schalter mit einer derartigen Dünnschicht-Mikrostruktur und entsprechendes Herstellunsverfahren
Microstructure à couches minces, MEMS-interrupteur avec cette microstructure à couches minces et procédé de fabrication correspondant

(30) Priority: 27.10.2004 KR 2004086056
(43) Date of publication of application: 03.05.2006
(73) Proprietor: Samsung Electronics Co., Ltd., Suwon-si, Gyeonggi-do (KR)
(72) Inventor: Kweon, Soon-cheol, Gangnam-gu Seoul (KR); Shin, Hyung-jae, Bundang-gu Seongnam-si Gyeonggi-do (KR); Jeon, Byung-hee, Seongnam-si Gyeonggi-do (KR); Hong, Seok-kwan, Gangnam-gu Seoul (KR); Kim, Che-heung, Yongin-si Gyeonggi-do (KR); Lee, Sang-hun, Seocho-gu Seoul (KR)
(74) Representative: Grünecker, Kinkeldey, Stockmair & Schwanhäusser Anwaltssozietät

(56) References cited:
- US-A1- 2002 027 487
- US-A1- 2003 042 117

## Description

### CROSS-REFERENCE TO RELATED APPLICATIONS

This application claims priority from Korean Patent Application No. 2004-86056, filed on October 27, 2004, in the Korean Intellectual Property Office.

### BACKGROUND OF THE INVENTION

### Field of the Invention

The present invention relates to a micro thin-film structure, a MEMS (Micro Electro-Mechanical System) switch employing such a micro thin-film structure, and methods of fabricating the micro thin-film structure and the MEMS switch, and in particular to a micro thin-film structure, which is improved in lamination structure to minimize the deformation of the micro thin-film structure and allows a MEMS switch to be stably operated when the micro thin-film structure is applied to a movable electrode of the MEMS switch, a MEMS switch employing such a micro thin-film structure, and methods of fabricating them.

### Description of the Related Art

Among RF devices fabricated using MEMS techniques, switches are most widely manufactured at present. RF switches are frequently applied to circuits for signal selection and transmission or impedance matching in radio frequency communication terminals and systems of microwave band or millimeter wave band.

An example of such an RF switch is disclosed in Japanese Patent Publication No. Hei 10-334778 issued on December 12, 1998 and entitled "Critical Microswitch and Its Manufacture."

Briefly, the microswitch comprises a movable electrode initially deformed by difference in residual stress, a fixed electrode spaced from the movable electrode, a movable electrode support portion for supporting both ends of the movable electrode, and a fixed electrode support portion for supporting the fixed electrode.

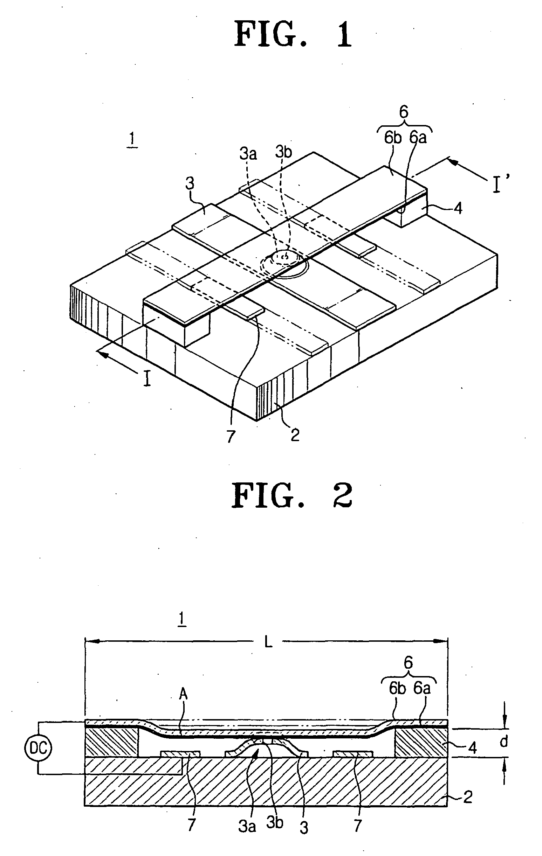

FIG. 1 is a perspective view showing a construction of a conventional MEMS switch, and FIG. 2 is a cross-sectional view taken along line I-I' of FIG. 1.

Referring to FIGS. 1 and 2, a signal line 3 having a dome-shaped contact 3a is formed on a substrate 2 at the central part of the top side of the substrate 2. A movable electrode 6 is positioned above the dome-shaped contact 3a, wherein the movable electrode 6 is fixed in a form of a simply-supported beam by spacers 4. A through-hole 3b is formed through the top of the dome-shaped contact 3a. A pair of fixed electrodes 7 are respectively positioned on the opposite sides of the signal line 3, wherein the fixed electrodes 7 cooperate with the movable electrode 6 to generate electrostatic force, thereby drawing the movable electrode 6 to come into contact with the dome-shaped contact 3a. The movable electrode 6 has a double thin-film structure having an electrode layer 6a formed from a conductive material and a reinforcement layer 6b formed on the top side of the electrode layer 6a to reinforce the strength of the electrode layer 6a.

In such a conventional MEMS switch, electrification is produced between the fixed electrodes when DC voltage is applied to the fixed electrodes 7 and the movable electrode 6 is drawn toward the substrate 2. As the movable electrode 6 is drawn, the central part of the movable electrode 6 comes into contact with the dome-shaped contact 3 a.

In order to ensure the stable switching operation of such an MEMS switch, it is necessary for the movable electrode 6 to maintain a horizontal posture without being deformed. However, there is a problem in that because the length L of the movable electrode 6 is relatively very large as compared to the distance d between the movable electrode 6 and the substrate 2, the movable electrode 6 is easily bent. Accordingly, a structure is demanded for effectively improving the flexural strength of the movable electrode 6.

However, the interface of the electrode layer 6a and the reinforcement layer 6b of the conventional movable electrode 6 is formed only as a horizontal plane A. Therefore, if stress is generated due to a difference in residual stress or thermal expansion coefficient caused in the electrode layer 6a and the reinforcement layer 6b after a thin-film has been formed, a face for canceling the generated stress is formed only by a horizontal plane. Therefore, there is a problem in that the effect of preventing the deformation of the movable electrode is insufficient.

Such deformation of a thin film structure may cause a problem not only in the above-mentioned MEMS switch but also in other devices employing MEMS techniques.

US 2003/042117 A1 discloses a high-speed MEMS with different embodiments. The corresponding MEMS comprises a beam of conductive material that is fixed at one end or is fixed at two ends. Below this beam there is an actuation electrode that will be used for producing an attractive electrostatic force between this electrode and the beam, such that this can be deflected downwards and will contact a second electrical contact, such that a circuit is closed between the first electrical contact and this second electrical contact. The beam is always made of only one material.

### SUMMARY OF THE INVENTION

It is an object of the present invention to provide a micro thin-film and an MEMS switch with an improved lamination structure to reduce the deformation of the corresponding films or layers and to simultaneously reduce deformation of the movable switch or the thin-film structure to obtain a stable switching operation.

This object is solved by the features of the independent claims.

Advantageous embodiments are disclosed by the features of the subclaims.

The top side of the electrode or lower layer may haves prominence and depression parts and the bottom side of the reinforcement or upper layer has a shape complementary to the prominence and depression parts of the lower layer.

The electrode or lower layer may be formed with plural through-holes, and the reinforcement or upper layer is formed to extend on the inner circumferential surfaces of the plural through-holes as well as on the top side of the lower layer. The through-holes may be formed in a shape selected from a group consisting of polygonal, circular and elliptical shapes.

Forming the interface between the upper and lower layers to be oriented to at least two directions may include the steps of depositing the lower layer to a predetermined thickness on a substrate; patterning the lower layer to form through-holes; and depositing the upper layer to a predetermined thickness on the top side of the lower layer in such a way that the upper layer extends to the inner circumferential surfaces of the through-holes in the form of being engaged in the through-holes, wherein the through-holes may be formed in a shape selected from a group consisting of polygonal, circular and elliptical shapes.

Alternatively, forming the interface between the upper and lower layers to be oriented to at least two directions may include the steps of depositing the lower layer to a predetermined thickness on a substrate; depositing a prominence and depression forming layer, made of the same material as the lower layer, on the lower layer to a predetermined thickness; patterning the prominence and depression forming layer to form prominence and depression parts on the lower layer; and depositing the upper layer to a predetermined thickness on the top side of the lower layer formed with the prominence and depression parts.

Forming the interface between the electrode layer and the reinforcement layer to be oriented to at least two directions may include the steps of patterning the electrode layer to form plural through-holes after the electrode has been deposited to a predetermined thickness; and depositing the reinforcement layer to a predetermined thickness on the top side of the electrode in such a way that the reinforcement layer is extended to the inner circumferential surfaces of the through-holes, wherein the through-holes may be formed in a shape selected from a group consisting of polygonal, circular and elliptical shapes.

According to an exemplary embodiment, a sacrifice layer may be laminated between the movable electrode and the substrate, and the through-holes may be used to remove the sacrifice layer in such a way that the movable electrode is formed to be spaced from the signal line.

Moreover, forming the interface between the electrode layer and the reinforcement layer to be oriented to at least two directions may include the steps of: depositing a prominence and depression forming layer having the same physical properties as the electrode layer after the electrode layer has been deposited to a predetermined thickness; patterning the prominence and depression forming layer to form prominence and depression parts on the electrode layer; and depositing the reinforcement layer to a predetermined thickness on the top side of the electrode layer formed with the prominence and depression parts.

### BRIEF DESCRIPTION OF THE DRAWINGS

The above aspects and features of the present invention will be more apparent from the description for certain embodiments of the present invention taken with reference to the accompanying drawings, in which:

FIG. 1 is a perspective view showing a construction of a conventional MEMS switch;

FIG. 2 is a cross-sectional view taken along line I-I' of FIG. 1;

FIG. 3 is a view showing a part of a micro thin-film structure 30 according to an exemplary embodiment of the present invention;

FIG. 4 is a view showing a part of a micro thin-film structure 50 according to another exemplary embodiment of the present invention;

FIGS. 5A to 5C are views showing steps of fabricating the thin-film structure 30 of FIG. 3;

FIGS. 6A to 6C are views showing steps of fabricating the thin-film structure 50 of FIG. 4;

FIG. 7 is a perspective view schematically showing a construction of an MEMS switch 100 according to an exemplary embodiment of the present invention;

FIG. 8 is an exploded perspective view of the MEMS switch of FIG. 7;

FIG. 9 is a top plan view of the MEMS switch of FIG. 7;

FIGS. 10A and 10B are views taken along line II-II' of FIG. 9, which illustrate the movement of an movable electrode of the inventive MEMS switch to come into contact with a signal line 107;

FIG. 10C is a view showing the part indicated by III in FIG. 10A in an enlarged scale;

FIG. 11A is a view showing another construction for preventing deformation of the movable electrode 111 for the inventive MEMS switch 100, wherein the micro thin-film structure 50 of FIG. 4 is applied to the movable electrode 111;

FIG. 11B is a view showing the part indicated by IV in FIG. 11A in an enlarged scale;

FIGS. 12A to 12E are cross-sectional views showing steps of fabricating the inventive MEMS switch 100 shown in FIGS. 10A to 10C; and

FIGS. 13A to 13E are cross-sectional views showing steps of fabricating the inventive MEMS switch 100 shown in FIGS. 11A and 11B.

### DETAILED DESCRIPTION OF THE EXEMPLARY NON-LIMITING EMBODIMENTS OF THE INVENTION

Hereinbelow, the exemplary embodiments of the present invention will be described in more detail with reference to the accompanying drawings.

The matters defined in the description such as a detailed arrangement and elements are nothing but the ones provided to assist in a comprehensive understanding of the invention. Thus, it is apparent that the present invention can be carried out without those defined matters. Also, well-known functions or arrangements in the art are not described in detail since they would unnecessarily obscure the invention. Further, the constructions shown in accompanying drawings are depicted in an enlarged scale as compared to practical sizes thereof

The inventive micro thin-film structure has two thin-films different in physical property and deposited in sequence to form upper and lower layers, wherein the interface between the upper and lower layers are formed to be oriented to two directions so as to minimize the deformation of the thin-film structure.

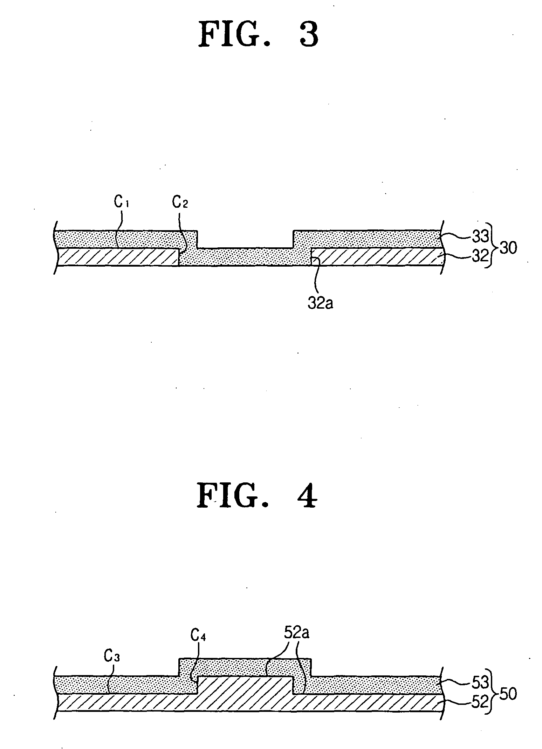

FIG. 3 shows a part of a micro thin-film structure 30 according to an exemplary embodiment of the present invention.

Referring to FIG. 3, the micro thin-film structure 30 comprises a lower layer 32 formed with plural through-holes 32a and an upper layer 33 formed to extend on the top surface of the lower layer 32 as well as on the inner circumferential surfaces of the plural through-holes 32a, so that the upper layer 31 is formed in an arrangement engaged in the plural through-holes 32a of the lower layer 32. At this time, the through-holes 32 may be take various shapes including polygonal, circular, elliptical shapes, for example.

With the above-mentioned construction, because the interface between the lower layer 32 and the upper layer 33 is oriented to the two directions of horizontal plane C₁ and vertical plane C₂, the stress cancellation effect of the thin film structure can be improved when stress is produced due to difference in residual stress and thermal expansion coefficient between the lower layer 32 and the upper layer 33. Therefore, the flexural rigidity of the thin-film structure 30 can be increased and the deformation of the thin-film structure 30 can be minimized.

FIG. 4 shows another construction of a thin-film structure 50 according to another exemplary embodiment of the invention.

Referring to FIG. 4, the top side of the lower layer 52 is formed with prominence and depression parts 52a and the bottom side of the upper layer 53 is formed in a complementary shape in relation to that of the top side of the lower layer 52.

In this construction, the interface between the two layers is also oriented to two directions of horizontal plane C₃ and vertical plane C₄. Therefore, it is possible to minimize the deformation of the thin-film structure 50.

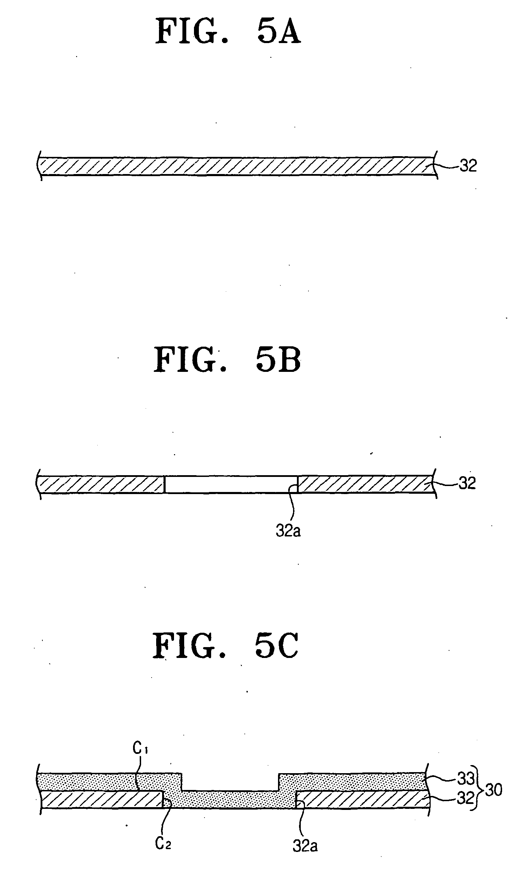

FIGS. 5A to 5C show steps of fabricating the thin-film structure 30 of FIG. 3.

At first, a lower layer 32 is deposited to a predetermined thickness on a process layer or substrate (not shown) prepared in a previous step as shown in FIG. 5A.

Next, the lower layer 32 is patterned to form plural through-holes 32a as shown in FIG. 5B.

Finally, an upper layer 33 is deposited to a predetermined thickness on the top side of the lower layer 32, in which the upper layer 33 is also deposited on the inner circumferential surfaces of the through-holes 32a, so that the interface between the upper and lower layers is oriented to the two directions of horizontal plane C₁ and vertical plane C₂, as shown in FIG. 5C.

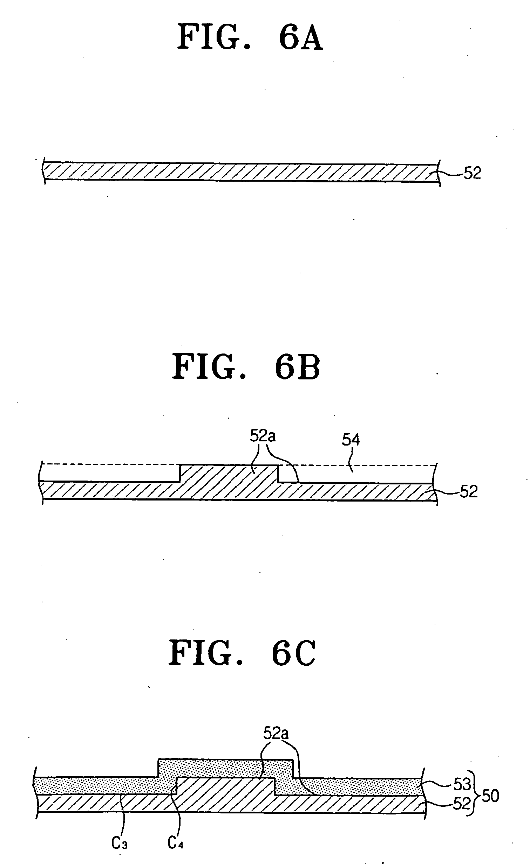

FIGS. 6A to 6C show steps of fabricating the thin-film structure 50 of FIG. 4.

At first, a lower layer 52 is deposited to a predetermined thickness on a process layer or substrate (not shown) prepared in previous step as shown in FIG. 6A.

Next, a second lower layer 54 is deposited on the lower layer 52 to a predetermined thickness, wherein the material of the second lower layer 54 is the same as that of the lower layer 52, and then the second lower layer 54 is patterned to form prominence and depression parts 52a, as shown in FIG. 6B.

Finally, an upper layer 53 is deposited to a predetermined thickness on the top side of the lower layer 52 formed with prominence and depression parts, so that the interface between the upper and lower layers is oriented to the two directions of horizontal plane C₃ and vertical plane C₄, as shown in FIG. 6C.

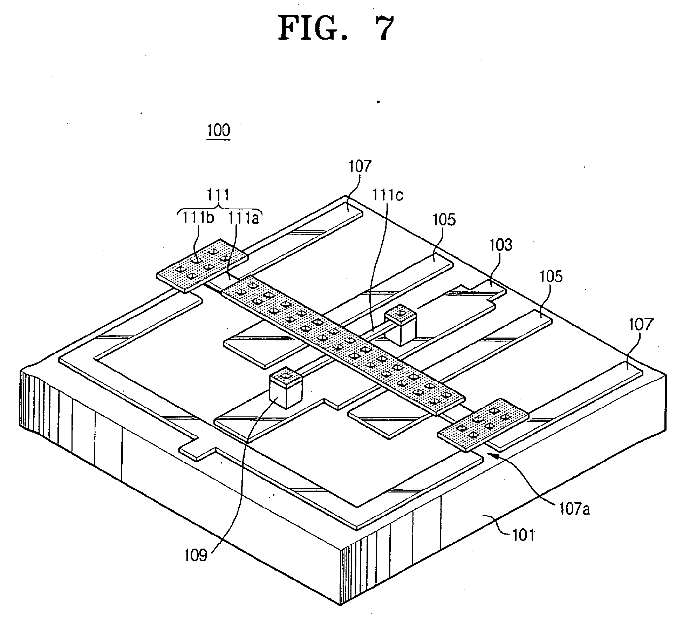

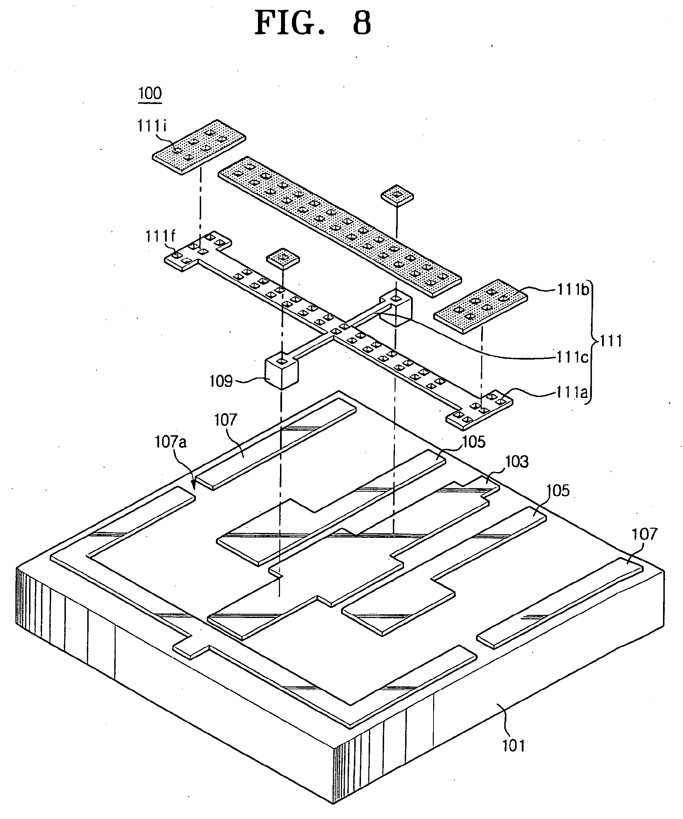

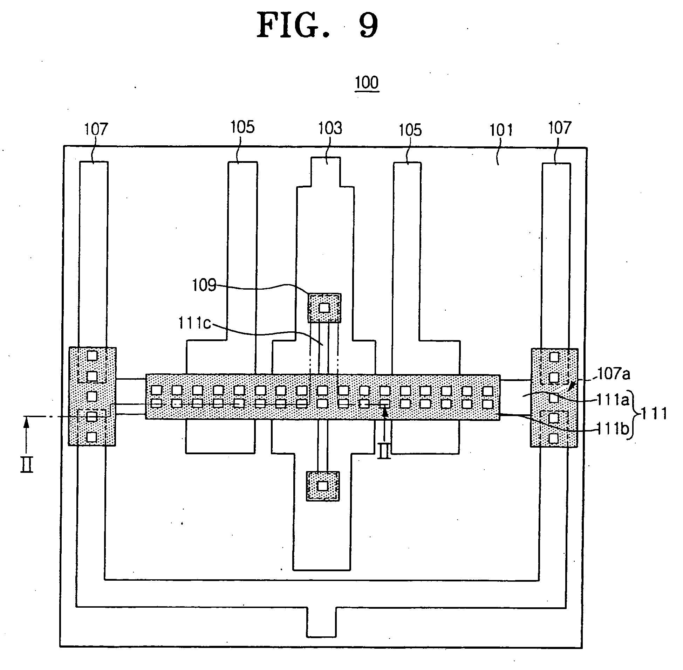

FIG. 7 is a perspective view schematically showing the construction of an MEMS switch 100 according to an exemplary embodiment of the present invention, FIG. 8 is an exploded perspective view of the MEMS switch 100, and FIG. 9 is a top plan view.

Referring to FIGS. 7 to 9, a ground line 103, one or more fixed electrodes 105 and one or more signal lines 107 are formed on the top side of the substrate 101 with a predetermined space being provided between them, wherein the ground line 103 is positioned at the central area between the fixed electrodes 105 (or the signal lines 107). Although it is possible to provide one fixed electrode 105 and one signal line 107, it is usual to provide a pair of fixed electrodes and a pair of signal lines, in such a manner that the fixed electrodes 105 and the signal lines 107 have a symmetrical arrangement with reference to the ground line 103, respectively.

In addition, a movable electrode 111 is provided at the longitudinal central part of the substrate 101 in a distance spaced from the signal lines 107 to perform seesaw movement about the central part thereof, so that the movable electrode 111 comes into selective contact with the contact portions 107a of the signal lines 107. The movable electrode 111 is a double thin-film structure with an electrode layer 111a and a reinforcement layer 111b formed on the top surface of the electrode layer 111a.

For the seesaw movement, the center part of the electrode layer 111a is connected to the top portions of spacers 109 through springs 111c, which extend from the opposite sides of the electrode layer 111a at the longitudinal central part thereof substantially vertical to the electrode layer 111a. The spacers 109 are in contact with the ground line 103 to ground the movable electrode 111.

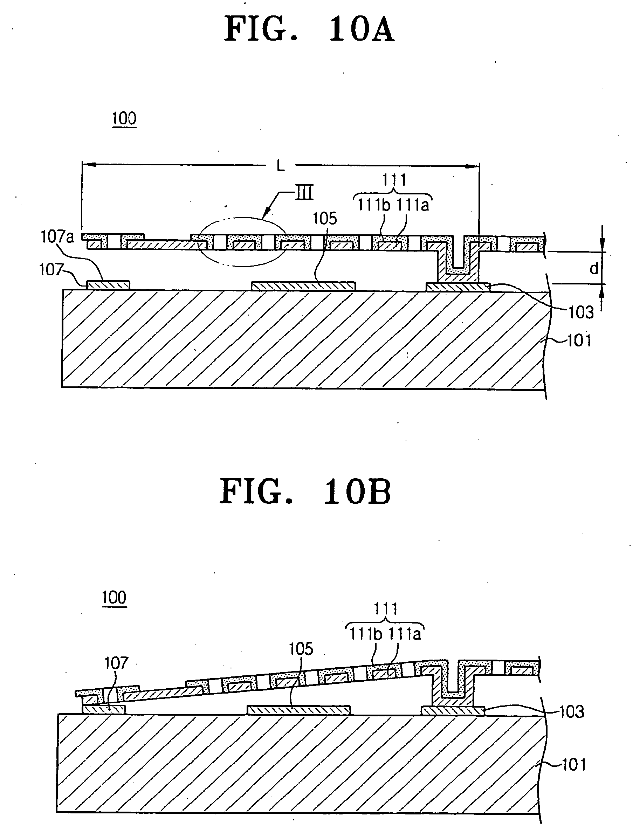

FIGS. 10A and 10B are cross-sectional views taken along line II-II' of FIG. 9, which illustrates the movement of the movable electrode 111 for coming into contact with the signal lines 107.

Referring to FIGS. 10A and 10B, if a predetermined level of voltage is applied to one of the fixed electrodes 105, electrification is produced between the voltage-applied fixed electrode 105 and one end of the movable electrode 111 corresponding to the electrode 105, whereby the one end of the movable electrode 111 is drawn toward the substrate 101 by electrostatic force. As a result, the one end of the movable electrode 111 comes into contact with a contact portion 107a of a corresponding signal line 107. If a predetermined level of voltage is applied to the other fixed electrode 105, the movable electrode 111 will perform seesaw movement to the opposite side and come into contact with the contact portion 107a of the other side signal line 107.

Because the movable electrode 111 is maintained at a distance d spaced from the substrate 101 and has a length L which is relatively larger than the distance d, the movable electrode 111 can be easily bent. Accordingly, there is potentially a problem that the switching movement is not stably performed.

However, according to an exemplary embodiment of the present invention, this problem is solved by applying the micro thin-film structures 30, 50 shown in FIGS. 3 and 4 to the movable electrode 111.

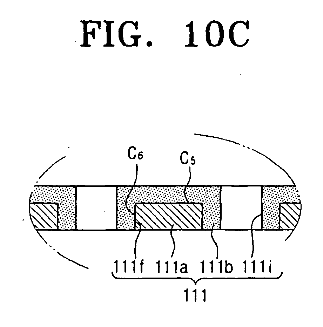

FIG. 10C is a view showing the part indicated by III in FIG. 10A in an enlarged scale, which uses the construction of the micro thin-film structure 30 of FIG. 3.

Referring to FIG. 10C, plural through-holes 111f are formed in the electrode layer 111 a and the reinforcement layer 111b is formed on the inner circumferential surfaces of the through-holes 111f as well as on the top side of the electrode layer 111a, whereby the reinforcement layer 111b is configured in the form of being engaged in the plural through-holes 111f. The reinforcement layer is patterned to form through-holes 111i to communicate with the through-holes in the electrode layer 111a.

Through this construction, the interface C5, C6 between the electrode layer 111a and the reinforcement layer 111b can cancel stress produced due to a difference in residual stress and/or thermal expansion coefficient between the electrode layer 111a and the reinforcement layer 111b of the movable electrode 111, whereby the deformation of the movable electrode 111 can be reduced. Therefore, the switching movement can be stably performed.

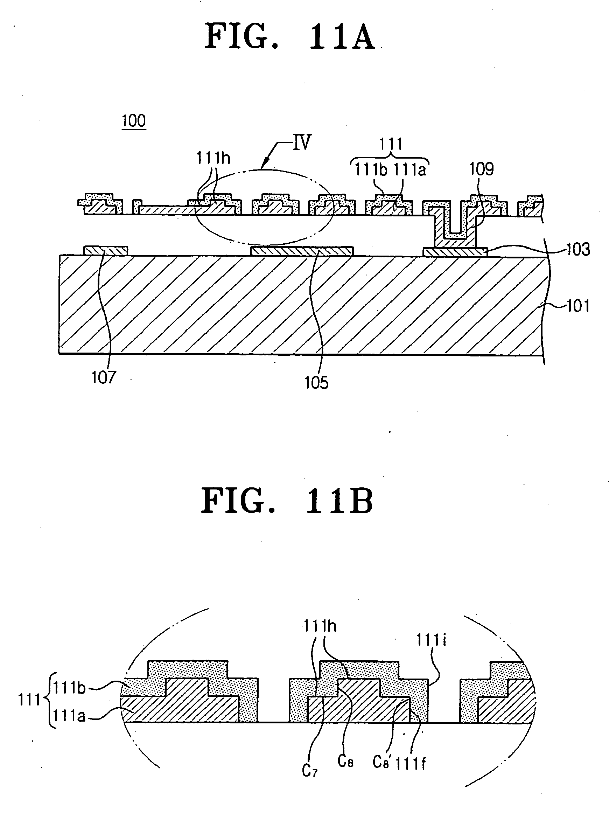

FIG. 11A shows another construction for preventing the deformation of the movable electrode 111 for the inventive MEMS switch 100, to which the micro thin-film structure 50 of FIG. 4 is applied, and FIG. 11B shows the part indicated by IV in FIG. 11A in an enlarged scale.

Referring to FIGS. 11A and 11B, prominence and depression parts 111h are formed on the top side of the electrode layer 111a, and the reinforcement layer 111b is formed in a shape complementary to the prominence and depression parts 111h. With this construction, the interface between the electrode layer 111a and the reinforcement layer 111b can cancel stress produced in the movable electrode 111, thereby minimizing the deformation of the movable electrode 111. In this embodiment, the through-holes 111f can be formed in the electrode layer 111a as shown in FIGS 10A to 10C and the reinforcement layer 111b can be deposited through the through-holes 111f so that the reinforcement layer 11 1b is configured in the form of being engaged in the through-holes 111f. If this construction is employed, the stress cancellation interface is increased because in addition to the horizontal interface C₇ and vertical interface C₈, an additional vertical interface C₈' is provided, whereby the flexural strength of the movable electrode 111 is further increased.

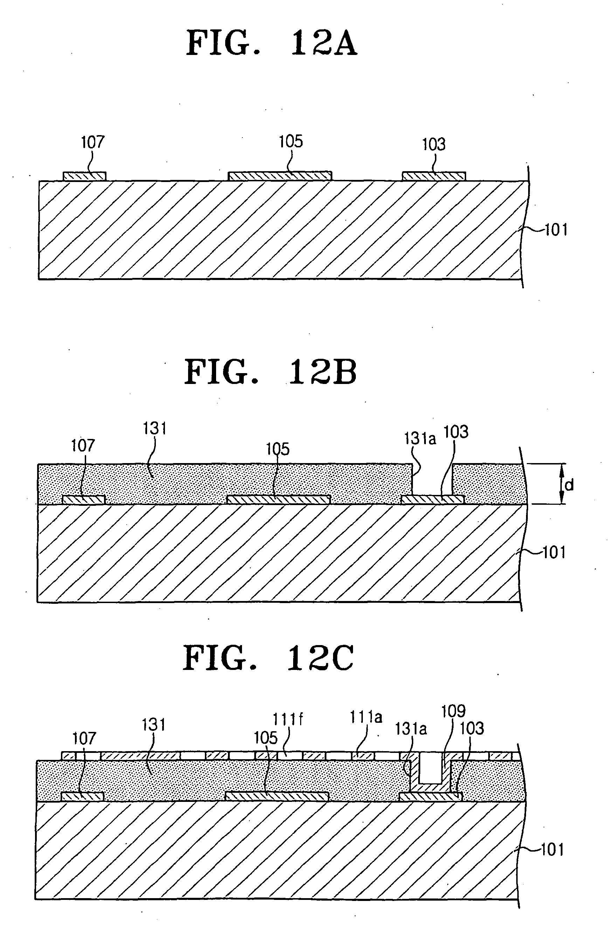

FIGS. 12A to 12E are cross-sectional views showing steps of fabricating the inventive MEMS switch 100 shown in FIGS. 10A to 10C.

At first, a conductive layer is deposited on a substrate 101 to a predetermined thickness and then patterned to form a ground line 103, one or more fixed electrodes 105, and one or more signal lines 107, as shown in FIG. 12A.

Following this, a sacrifice layer 131 is formed on the entire surface of the substrate 101 as shown in FIG. 12B. The sacrifice layer 131 serves to make the electrode layer 111a of the movable electrode 111 come into contact with the ground layer 103 and to maintain the movable electrode 111 at a distance d spaced apart from the substrate 101, and a contact hole 131a is formed in the sacrifice layer 131, wherein a spacer 109 to be laminated in the next step will be formed to be engaged in the contact holes 131a.

Next, aluminum is deposited to a predetermined thickness on the top surface of the sacrifice layer 131 to form the electrode layer 111a of the movable electrode 111. The electrode layer 111a is deposited while being in contact with the ground line 103 through the contact hole 131a. In order to etch the sacrifice layer 131, the electrode layer 111a is patterned to form through-holes 111f. The through-holes 111f are same with the through-holes 111f of FIG. 10C, wherein the through-holes 111f are employed for use in preventing the deformation of the movable electrode 111 as well as in etching the sacrifice layer 131.

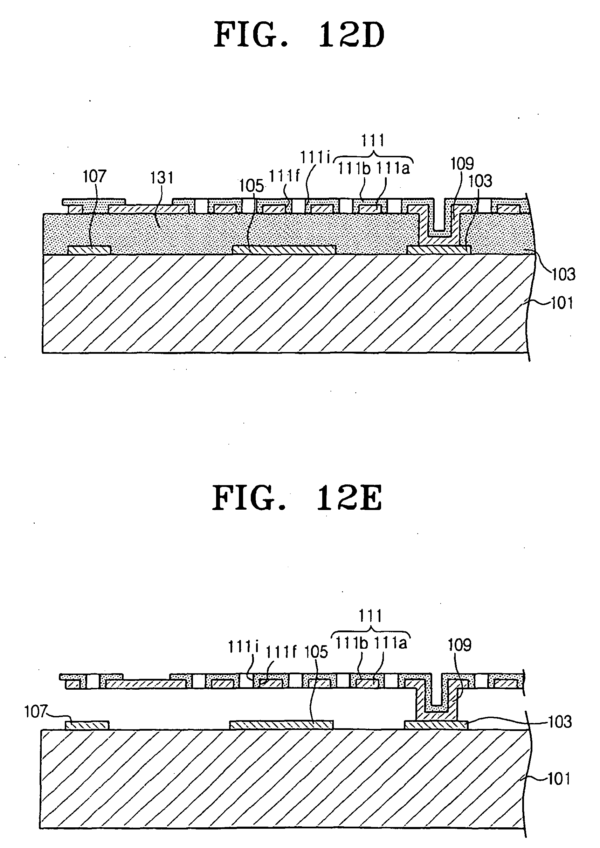

In addition, silicon nitride is deposited on the top surface of the electrode layer 111 a to a predetermined thickness to form the reinforcement layer 111b, as shown in FIG. 12D. The reinforcement layer 111b is deposited on the inner circumferential surfaces of the through-holes 111f as well as on the top surface of the electrode layer 111a, thereby increasing the flexural strength of the movable electrode 111. In order to etch the sacrifice layer 131, the reinforcement layer 111b is patterned to form through-holes 111i to communicate with the through-holes 111f formed in the electrode layer 111a.

Finally, the sacrifice layer 131 is removed by an etching process performed through the through-holes 111i as shown in FIG. 12E, thereby completing the MEMS switch 100.

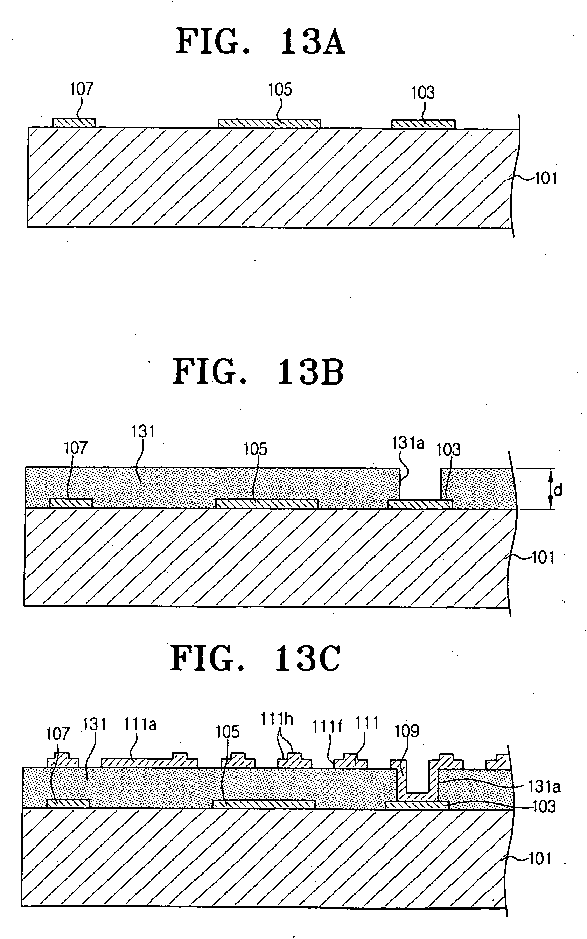

FIGS. 13A to 13E are cross-sectional views showing steps of fabricating another MEMS switch 100 according to the exemplary embodiment of the present invention shown in FIGS. 11A and 11B.

FIGS. 13A and 13B show steps until a sacrifice layer 131 is deposited on a substrate 101, which steps are equal to those shown in FIGS. 12A and 12B. Therefore, description thereof is omitted.

Next, aluminum is deposited on the top surface of the sacrifice layer 131 to a predetermined thickness to form an electrode layer 111a of a movable electrode 111, as shown in FIG. 13C. The electrode layer 111a is deposited while being in contact with a ground line 103 through the contact hole 131a. In order to increase the interface between the electrode layer 111a and a reinforcement layer 111b to be laminated in the next step, a second aluminum layer (not shown) is deposited on the previously deposited aluminum layer and then patterned to form prominence and depression parts 111h. In this exemplary embodiment, in order to etch the sacrifice layer 131, it is possible to pattern the electrode layer 111a to form through-holes 111f, as shown in FIG. 12C. Such through-holes 111f are the same as the through-holes 111f of FIG. 11A; they are employed for use in preventing the deformation of the movable electrode 111 as well as in etching the sacrifice layer 131.

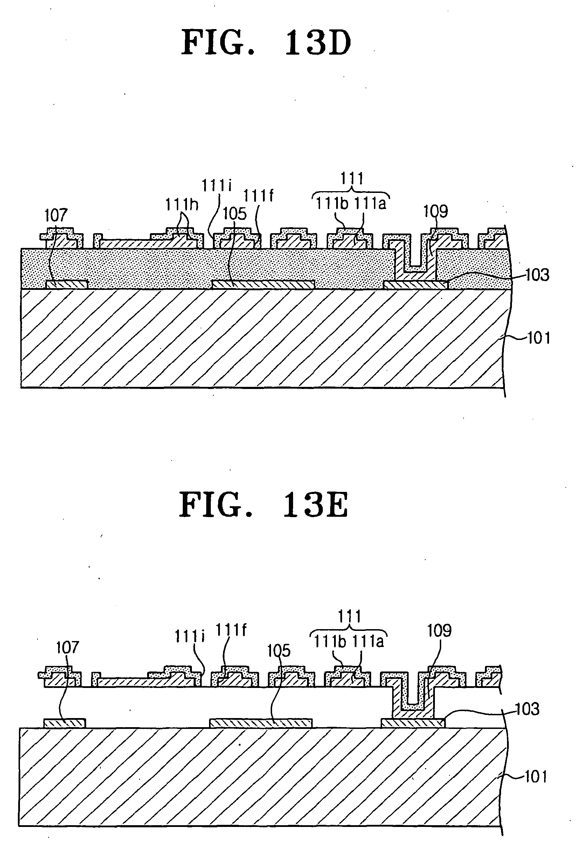

Next, silicon nitride is deposited to a predetermined thickness on the top surface of the electrode layer 111a formed with the prominence and depression parts 111h to form the reinforcement layer 111b, as shown in FIG. 13D. The reinforcement layer 111b is deposited on the top surface of the electrode layer 111a to the predetermined thickness in a shape complementary to the top surface of the electrode 111a with the prominence and depression parts 111h. The reinforcement layer 111b is also deposited on the inner circumferential surfaces of the through-holes 111f, thereby increasing the flexural strength of the movable electrode 111.

At this time, etching holes 111i are formed through the reinforcement layer 111b to communicate with the through-holes 111f of the electrode layer 111a.

Finally, the sacrifice layer 131 is removed by an etching process performed through the through-holes 111i as shown in FIG. 13E, thereby completing the MEMS switch 100.

Although an arrangement, in which the movable electrode 111 comes into contact with the signal lines 107, has been described above by way of an example, the movable electrode 111 may take a form of a simple supported beam with both ends being fixed in relation to the substrate 101, a form of a cantilever with a fixed end fixed in relation to the substrate 101 and a free end opposite to the fixed end, or a form of a membrane entirely fixed in relation to the substrate 101.

A micro thin-film structure configured as described above has an advantage of minimizing the deformation of the micro thin-film structure.

In addition, if a micro thin-film structure configured as described above is applied to a movable electrode of an MEMS switch, there is an advantage in that the deformation of the movable electrode can be minimized and thus the switching operation of the MEMS switch can be stably performed.

While exemplary embodiments of the present invention have been shown and described in order to exemplify the principle of the present invention, the present invention is not limited to the specific embodiments.

## Claims

1. A micro thin-film structure (30,50) comprising at least two thin-films (32,33; 52,53) having different physical properties and laminated in sequence to form an upper layer and a lower layer, **characterized by** an interface between the upper and lower layers is formed to be oriented to two directions of horizontal plane (C₁) and vertical plane (C₂).

2. A micro thin-film structure as claimed in claim 1, wherein a top side of the lower layer (52) has prominence and depression parts (52a) and a bottom side of the upper layer (53) has a shape complementary to the prominence and depression parts of the lower layer.

3. A micro thin-film structure as claimed in claim 1, wherein the lower layer (32) is formed with plural through-holes (32a), and the upper layer (33) is formed to extend on inner circumferential surfaces of the plural through-holes as well as on a top side of the lower layer.

4. A micro thin-film structure as claimed in claim 3, wherein the through-holes (32a) are formed in a shape comprising at least one of polygonal, circular and elliptical shapes.

5. An MEMS switch (100) comprising:
a substrate (101);
a signal line (107) formed on a top side of the substrate (101); and
a movable electrode (111) formed spaced apart from the substrate (101) to electrically contact with the signal line (107), **characterized in that** the movable electrode comprises an electrode layer (111a) and a reinforcement layer (111b) formed on a top side of the electrode layer, and wherein an interface between the electrode layer and the reinforcement layer is formed to be oriented to two directions of horizontal plane (C₁) and vertical plane (C₂).

6. An MEMS switch as claimed in claim 5, wherein the top side of the electrode layer (111a) has prominence and depression parts (111b) and a bottom side of the reinforcement layer (111 b) has a shape complementary to the prominence and depression parts of the electrode layer.

7. An MEMS switch as claimed in claim 5, wherein the electrode layer (111a) is formed with plural through-holes (111f), and the reinforcement layer (111b) is formed to extend on inner circumferential surfaces of the plural through-holes as well as on the top side of the electrode layer.

8. An MEMS switch as claimed in claim 7, wherein the through-holes (111f) are formed in a shape comprising at least one of polygonal, circular and elliptical shapes.

9. A method of fabricating a micro thin-film structure (30,50) **characterized by** laminating at least two thin-films (32,33; 52,53) having different properties to form upper and lower layers in sequence, wherein an interface between the upper and lower layers is formed to be oriented to two directions of horizontal plane (C₁) and vertical plane (C₂).

10. A method as claimed in claim 9, wherein forming the interface between the upper and lower layers to be oriented to at least two directions comprises the steps of:
depositing the lower layer (32) to a predetermined thickness on a substrate;
patterning the lower layer to form through-holes (32a); and
depositing the upper layer (33) to a predetermined thickness on a top side of the lower layer in such a way that the upper layer extends to inner circumferential surfaces of the through-holes (32a) and is engaged in the through-holes.

11. A method as claimed in claim 10, wherein the through-holes (32a) are formed in a shape comprising at least one of polygonal, circular and elliptical shapes.

12. A method as claimed in claim 9, wherein forming the interface between the upper and lower layers to be oriented to at least two directions comprises the steps of:
depositing the lower layer (52) to a predetermined thickness on a substrate;
depositing a prominence and depression forming layer, made of the same material as the lower layer (52), on the lower layer to a predetermined thickness;
patterning the prominence and depression forming layer to form prominence and depression parts (52a) on the lower layer; and
depositing the upper layer (53) to a predetermined thickness on a top side of the lower layer formed with the prominence and depression parts.

13. A method of manufacturing an MEMS switch (100) comprising steps of:
forming a signal line (107) on a substrate (101); and
forming a movable electrode (111), which is positioned spaced apart from the substrate (101) and to electrically contact with the signal line (107), wherein the step of forming the movable electrode is **characterized by** the steps of:
depositing an electrode layer (111a), and
depositing a reinforcement layer (111 b) on a top side of the electrode layer (111 a), wherein an interface between the electrode layer and the reinforcement layer is formed to be oriented to two directions of horizontal plane (C₁) and vertical plane (C₂).

14. A method as claimed in claim 13, wherein forming the interface between the electrode layer and the reinforcement layer to be oriented to at least two directions comprises steps of:
patterning the electrode layer (111a) to form plural through-holes (111f) after the electrode layer has been deposited to a predetermined thickness; and
depositing the reinforcement layer (111 b) to a predetermined thickness on a top side of the electrode layer in such a way that the reinforcement layer is extended to inner circumferential surfaces of the through-holes (111f).

15. A method as claimed in claim 14, wherein the through-holes (111f) are formed in a shape comprising at least one of polygonal, circular and elliptical shapes.

16. A method as claimed in claim 15, wherein a sacrifice layer (131) is laminated between the movable electrode (111) and the substrate (101), and the through-holes (111f) are used to remove the sacrifice layer in such a way that the movable electrode is formed to be spaced apart from the signal line.

17. A method as claimed in claim 13, wherein forming the interface between the electrode layer and the reinforcement layer to be oriented to at least two directions comprises steps of:
depositing a prominence and depression forming layer having the same properties as the electrode layer after the electrode layer has been deposited to a predetermined thickness;
patterning the prominence and depression forming layer to form prominence and depression parts (111 b) on the electrode layer (111 a); and
depositing the reinforcement layer (111b) to a predetermined thickness on a top side of the electrode layer formed with the prominence and depression parts.

## Patentansprüche

1. Mikro-Dünnfilmstruktur (30, 50), die wenigstens zwei Dünnfilme (32, 33; 52, 53) umfasst, die unterschiedliche physikalische Eigenschaften haben und so aufeinanderfolgend geschichtet sind, dass eine obere Schicht und eine untere Schicht entsteht, **dadurch gekennzeichnet, dass** eine Grenzfläche zwischen der oberen und der unteren Schicht so ausgebildet ist, dass sie in zwei Richtungen einer horizontalen Ebene (C₁) und einer vertikalen Ebene (C₂) ausgerichtet ist.

2. Mikro-Dünnfilmstruktur nach Anspruch 1, wobei eine obere Seite der unteren Schicht (52) Vorsprungs- und Vertiefungsteile (52a) aufweist und eine untere Seite der oberen Schicht (53) eine Form hat, die komplementär zu den Vorsprungs- und Vertiefungsteilen der unteren Schicht ist.

3. Mikro-Dünnfilmstruktur nach Anspruch 1, wobei die untere Schicht (32) mit mehreren Durchgangslöchern (32a) versehen ist und die obere Schicht (33) so ausgebildet ist, dass sie sich an Innenumfangsflächen der mehreren Durchgangslöcher sowie an einer oberen Seite der unteren Schicht erstreckt.

4. Mikro-Dünnfilmstruktur nach Anspruch 3, wobei die Durchgangslöcher (32a) in einer Form ausgebildet sind, die Vieleck-, Kreis- oder/und Ellipsenformen umfasst.

5. MEMS-Schalter (100), der umfasst:
ein Substrat (101);
eine Signalleitung (107), die an einer Oberseite des Substrats (101) ausgebildet ist; und
eine bewegliche Elektrode (111), die von dem Substrat (101) beabstandet ausgebildet ist und in elektrischem Kontakt mit der Signalleitung (107) ist, **dadurch gekennzeichnet, dass** die bewegliche Elektrode eine Elektrodenschicht (111a) und eine Verstärkungsschicht (111 b) umfasst, die an einer Oberseite der Elektrodenschicht ausgebildet ist, und wobei eine Grenzfläche zwischen der Elektrodenschicht und der Verstärkungsschicht so ausgebildet ist, dass sie in zwei Richtungen einer horizontalen Ebene (C₁) und einer vertikalen Ebene (C₂) ausgerichtet ist.

6. MEMS-Schalter nach Anspruch 5, wobei die obere Seite der Elektrodenschicht (111a) Vorsprungs- und Vertiefungsteile (111 b) aufweist und eine untere Seite der Verstärkungsschicht (111 b) eine Form hat, die komplementär zu den Vorsprungs- und Vertieferteilen der Elektrodenschicht ist.

7. MEMS-Schalter nach Anspruch 5, wobei die Elektrodenschicht (111a) mit mehreren Durchgangslöchern (111f) versehen ist und die Verstärkungsschicht (111b) so ausgebildet ist, dass sie sich an Innenumfangsflächen der mehreren Durchgangslöcher sowie an der oberen Seite der Elektrodenschicht erstreckt.

8. MEMS-Schalter nach Anspruch 7, wobei die Durchgangslöcher (111f) in einer Form ausgebildet sind, die Vieleck-, Kreis- oder/und Ellipsen-Formen umfasst.

9. Verfahren zum Herstellen einer Mikro-Dünnfilmstruktur (30, 50), **gekennzeichnet durch** Schichten wenigstens zweier Dünnfilme (32, 33; 52, 53), die unterschiedliche Eigenschaften haben, um eine obere und eine untere Schicht aufeinanderfolgend auszubilden, wobei eine Grenzfläche zwischen der oberen und der unteren Schicht so ausgebildet ist, dass sie in zwei Richtungen einer horizontalen Ebene (C₁) und einer vertikalen Ebene (C₂) ausgerichtet ist.

10. Verfahren nach Anspruch 9, wobei Ausbilden der Grenzfläche zwischen der oberen und der unteren Schicht, so dass in wenigstens zwei Richtungen ausgerichtet ist, die folgenden Schritte umfasst:
Aufbringen der unteren Schicht (32) in einer vorgegebenen Dicke auf einem Substrat;
Strukturieren der unteren Schicht, um Durchgangslöcher (32a) auszubilden; und
Aufbringen der oberen Schicht (33) in einer vorgegebenen Dicke auf einer oberen Seite der unteren Schicht, so dass sich die obere Schicht zu Innenumfangsflächen der Durchgangslöcher (32a) erstreckt und in die Durchgangslöcher eingreift.

11. Verfahren nach Anspruch 10, wobei die Durchgangslöcher (32a) in einer Form ausgebildet sind, die Vieleck-, Kreis- oder/und Ellipsen-Formen umfasst.

12. Verfahren nach Anspruch 9, wobei Ausbilden der Grenzfläche zwischen der oberen und der unteren Schicht, so dass sie in wenigstens zwei Richtungen ausgerichtet ist, die folgenden Schritte umfasst:
Aufbringen der unteren Schicht (52) in einer vorgegebenen Dicke auf einem Substrat;
Aufbringen einer Vorsprünge und Vertiefungen bildenden Schicht, die aus dem gleichen Material besteht wie die untere Schicht (52), auf der unteren Schicht in einer vorgegebenen Dicke;
Strukturieren der Vorsprünge und Vertiefungen bildenden Schicht, um Vorsprungs- und Vertiefungsteile (52a) auf der unteren Schicht auszubilden; und
Aufbringen der oberen Schicht (53) in einer vorgegebenen Dicke auf einer oberen Seite der unteren Schicht, die mit Vorsprungs- und Vertiefungsteilen versehen ist.

13. Verfahren zum Herstellen eines MEMS-Schalters (100), das die folgenden Schritte umfasst:
Ausbilden einer Signalleitung (107) auf einem Substrat (101); und
Ausbilden einer beweglichen Elektrode (111), die von dem Substrat (101) beabstandet angeordnet und in elektrischem Kontakt mit der Signalleitung (107) ist, wobei der Schritt des Ausbildens der beweglichen Elektrode durch die folgenden Schritte **gekennzeichnet** ist:
Aufbringen einer Elektrodenschicht (111a), und
Aufbringen einer Verstärkungsschicht (111 b) auf einer oberen Seite der Elektrodenschicht (111a), wobei eine Grenzfläche zwischen der Elektrodenschicht und der Verstärkungsschicht so ausgebildet ist, dass sie in zwei Richtungen einer horizontalen Ebene (C₁) und einer vertikalen Ebene (C₂) ausgerichtet ist.

14. Verfahren nach Anspruch 13, wobei Ausbilden der Grenzfläche zwischen der Elektrodenschicht und der Verstärkungsschicht, so dass sie in wenigstens zwei Richtungen ausgerichtet ist, die folgenden Schritte umfasst:
Strukturieren der Elektrodenschicht, um mehrere Durchgangslöcher (111f) auszubilden, nachdem die Elektrodenschicht in einer vorgegebenen Dicke aufgebracht worden ist; und
Aufbringen der Verstärkungsschicht (111 b) in einer vorgegebenen Dicke auf einer Oberseite der Elektrodenschicht, so dass sich die Verstärkungsschicht zu Innenumfangsflächen der Durchgangslöcher (111f) erstreckt.

15. Verfahren nach Anspruch 14, wobei die Durchgangslöcher (111f) in einer Form ausgebildet sind, die Vieleck-, Kreis- oder/und Ellipsen-Formen umfasst.

16. Verfahren nach Anspruch 15, wobei eine Opferschicht (131) zwischen die bewegliche Elektrode (111) und das Substrat (101) geschichtet wird und die Durchgangslöcher (111f) verwendet werden, um die Opferschicht so zu entfernen, dass die bewegliche Elektrode von der Signalleitung beabstandet ausgebildet wird.

17. Verfahren nach Anspruch 13, wobei Ausbilden der Grenzfläche zwischen der Elektrodenschicht und der Verstärkungsschicht, so dass sie in wenigstens zwei Richtungen ausgerichtet ist, die folgenden Schritte umfasst:
Aufbringen einer Vorsprünge und Vertiefungen bildenden Schicht, die die gleichen Eigenschaften hat wie die Elektrodenschicht, nachdem die Elektrodenschicht in einer vorgegebenen Dicke aufgebracht worden ist;
Strukturieren der Vorsprünge und Vertiefungen bildenden Schicht, um Vorsprungs- und Vertiefungsteile (111 b) auf der Elektrodenschicht (111 a) auszubilden; und
Aufbringen der Verstärkungsschicht (111 b) in einer vorgegebenen Dicke auf einer oberen Seite der Elektrodenschicht, die mit den Vorsprungs- und Vertiefungsteilen versehen ist.

## Revendications

1. Microstructure à couches minces (30, 50) comprenant au moins deux couches minces (32, 33 ; 52, 53) ayant différentes propriétés physiques et laminées en séquence pour former une couche supérieure et une couche inférieure, **caractérisée en ce qu'**une interface entre les couches supérieure et inférieure est formée pour être orientée selon deux directions d'un plan horizontal (C₁) et d'un plan vertical (C₂).

2. Microstructure à couches minces selon la revendication 1, dans laquelle un côté supérieur de la couche inférieure (52) comporte des éléments de protubérance et de dépression (52a) et un côté inférieur de la couche supérieure (53) présente une forme complémentaire aux éléments de protubérance et de dépression de la couche inférieure.

3. Microstructure à couches minces selon la revendication 1, dans laquelle la couche inférieure (32) est formée avec une pluralité de trous traversants (32a), et la couche supérieure (33) est formée pour s'étendre sur des surfaces internes circonférentielles de la pluralité de trous traversants ainsi que sur un côté supérieur de la couche inférieure.

4. Microstructure à couches minces selon la revendication 3, dans laquelle la conformation des trous traversants (32a) comprend au moins une forme polygonale, circulaire ou elliptique.

5. Interrupteur MEMS (100) comprenant :
un substrat (101) ;
une ligne de signal (107) formée sur un côté supérieur du substrat (101) ; et
une électrode mobile (111) formée de manière à être espacée du substrat (101) pour établir un contact électrique avec la ligne de signal (107), **caractérisé en ce que** l'électrode mobile comprend une couche d'électrode (111a) et une couche de renforcement (111b) formées sur un côté supérieur de la couche d'électrode, et dans lequel une interface entre la couche d'électrode et la couche de renforcement est formée pour être orientée selon deux directions d'un plan horizontal (C₁) et d'un plan vertical (C₂).

6. Interrupteur MEMS selon la revendication 5, dans lequel le côté supérieur de la couche d'électrode (111a) comporte des éléments de protubérance et de dépression (111b) et un côté inférieur de la couche de renforcement (111) présente une forme complémentaire aux éléments de protubérance et de dépression de la couche d'électrode.

7. Interrupteur MEMS selon la revendication 5, dans lequel la couche d'électrode (111a) est formée avec une pluralité de trous traversants (111), et la couche de renforcement (111b) est formée pour s'étendre sur des surfaces internes circonférentielles de la pluralité de trous traversants ainsi que sur le côté supérieur de la couche d'électrode.

8. Interrupteur MEMS selon la revendication 7, dans lequel la conformation des trous traversants (111f) comprend au moins une forme polygonale, circulaire ou elliptique.

9. Procédé de fabrication d'une microstructure à couches minces (30,50) **caractérisé par** le laminage d'au moins deux couches minces (32, 33 ; 52, 53) ayant différentes propriétés pour former des couches supérieure et inférieure en séquence, dans lequel une interface entre les couches supérieure et inférieure est formée pour être orientée selon deux directions d'un plan horizontal (C₁) et d'un plan vertical (C₂).

10. Procédé selon la revendication 9, dans lequel la formation de l'interface entre les couches supérieure et inférieure à orienter selon au moins deux directions comprend les étapes consistant à :
déposer la couche inférieure (32) selon une épaisseur prédéterminée sur un substrat ;
établir la couche inférieure selon un motif pour former des trous traversants (32a) ; et
déposer la couche supérieure (33) selon une épaisseur prédéterminée sur un côté supérieur de la couche inférieure de telle manière que la couche supérieure s'étend jusqu'aux surfaces circonférentielles internes des trous traversants (32a) et est engagée dans les trous traversants.

11. Procédé selon la revendication 10, dans lequel la conformation des trous traversants (32a) comprend au moins une forme polygonale, circulaire ou elliptique.

12. Procédé selon la revendication 9, dans lequel la formation de l'interface entre les couches supérieure et inférieure à orienter selon au moins deux directions comprend les étapes consistant à :
déposer la couche inférieure (52) selon une épaisseur prédéterminée sur un substrat ;
déposer une couche de formation de protubérances et de dépressions, constituée du même matériau que la couche inférieure (52), sur la couche inférieure selon une épaisseur prédéterminée ;
établir la couche de formation de protubérances et de dépressions selon un motif pour former des éléments de protubérance et de dépression (52a) sur la couche inférieure ; et
déposer la couche supérieure (53) selon une épaisseur prédéterminée sur un côté supérieur de la couche inférieure formée avec les éléments de protubérance et de dépression.

13. Procédé de fabrication d'un interrupteur MEMS (100) comprenant les étapes consistant à :
former une ligne de signal (107) sur un substrat (101) ; et
former une électrode mobile (111) espacée du substrat (101) pour établir un contact électrique avec la ligne de signal (107), dans lequel l'étape de formation de l'électrode mobile est **caractérisée par** les étapes consistant à :
déposer une couche d'électrode (111a), et
déposer une couche de renforcement (111b) sur un côté supérieur de la couche d'électrode (111a), dans lequel une interface entre la couche d'électrode et la couche de renforcement est formée pour être orientée selon deux directions d'un plan horizontal (C₁) et d'un plan vertical (C₂) .

14. Procédé selon la revendication 13, dans lequel la formation de l'interface entre la couche d'électrode et la couche de renforcement à orienter selon au moins deux directions comprend les étapes consistant à :
établir la couche d'électrode (111a) selon un motif pour former une pluralité de trous traversants (111f) après que la couche d'électrode soit déposée selon une épaisseur prédéterminée ; et
déposer la couche de renforcement (111b) selon une épaisseur prédéterminée sur un côté supérieur de la couche d'électrode, de telle manière que la couche de renforcement s'étend jusqu'aux surfaces circonférentielles internes des trous traversants (111f).

15. Procédé selon la revendication 14, dans lequel la conformation des trous traversants (111f) comprend au moins une forme polygonale, circulaire ou elliptique.

16. Procédé selon la revendication 15, dans lequel une couche sacrificielle (131) est laminée entre l'électrode mobile (111) et le substrat (101), et les trous traversants (111f) sont utilisés pour éliminer la couche sacrificielle de telle manière que l'électrode mobile est formée pour être espacée de la ligne de signal.

17. Procédé selon la revendication 13, dans lequel la formation de l'interface entre la couche d'électrode et la couche de renforcement à orienter selon au moins deux directions comprend les étapes consistant à :
déposer une couche de formation de protubérances et de dépressions ayant les mêmes propriétés que la couche d'électrode après avoir déposé la couche d'électrode selon une épaisseur prédéterminée ;
établir la couche de formation de protubérances et de dépressions selon un motif pour former des éléments de protubérance et de dépression (111b) sur la couche d'électrode (111a) ; et
déposer une couche de renforcement (111b) selon une épaisseur prédéterminée sur un côté supérieur de la couche d'électrode formée avec les éléments de protubérance et de dépression.
